# EUROPÄISCHE PATENTSCHRIFT

(11) **EP 1 175 009 B1**
(45) Veröffentlichungstag und Bekanntmachung des Hinweises auf die Patenterteilung: **21.03.2012**
(21) Anmeldenummer: 01114633.9
(22) Anmeldetag: 19.06.2001
(51) Int. Cl.: H03K 3/57

(54) **Kompakte Pulsstromversorgung**
Compact current pulse supply
Alimentation en impulsions de courant compacte

(30) Priorität: 05.07.2000 DE 10032639
(43) Veröffentlichungstag der Anmeldung: 23.01.2002
(73) Patentinhaber: Rheinmetall Waffe Munition GmbH, 29345 Unterlüss (DE)
(72) Erfinder: Podeyn, Frank, 29351 Eldingen (DE); Weise, Thomas, Dr., 29345 Unterlüss (DE)
(74) Vertreter: Dietrich, Barbara

(56) Entgegenhaltungen:
- DE-A1- 3 623 304
- DE-C- 606 241
- DE-C- 682 583
- US-A- 3 321 689
- US-A- 5 559 404
- US-A- 5 914 974
- RANJAN P ET AL: "AUDIO-FREQUENCY DISCHARGE CLEANING SYSTEM FOR THE SINP TOKAMAK USING SINGLE TURN PROMARY" REVIEW OF SCIENTIFIC INSTRUMENTS, AMERICAN INSTITUTE OF PHYSICS. NEW YORK, US, Bd. 65, Nr. 1, Januar 1994 (1994-01), Seiten 135-139, XP000428559 ISSN: 0034-6748

## Beschreibung

Die Erfindung betrifft eine kompakte Pulsstromversorgung zur Erzeugung von insbesondere Hochleistungspulsen nach dem Oberbegriff des Patentanspruches 1.

Energieversorgungssysteme, die Energien im Leistungsbereich von einigen Megawatt (MW) bis Gigawatt (GW) innerhalb einer Pulsdauer von wenigen Millisekunden (ms) bereitstellen, nennt man Pulsstromversorgungen. Solche Pulsstromversorgungen sind unabhängig von der Menge der gespeicherten Energie und bestehen prinzipiell aus einem Ladegerät zum Aufladen eines Energiespeichers, mehreren Plattenkondensatoren als Energiespeicher, einem Hochleistungsschalter zur Freigabe der gespeicherten Energie, sowie einer Pulsformeinrichtung.

In der DE 195 32 219 A1 ist ein solcher Aufbau in einem Blockschaltbild offenbart. Als Pulsformeinrichtung fungiert hierbei eine Hochleistungsfunkenstrecke, die von der Pulsstromversorgung eine Spannung von ca. 250 KV und einen Strom von bis zu 100 KA geliefert bekommt. Der insbesondere für die Speicherung der Energie notwendige Bauraum macht die Pulsstromversorgung sehr aufwendig, massiv und kostenintensiv.

Hieraus ergibt sich die Aufgabe der Erfindung, eine Pulsstromversorgung aufzuzeigen, bei der der notwendige Bauraum reduziert ist, so daß diese platzsparend aufgebaut und somit auch mobil einsetzbar ist.

Gelöst wird die Aufgabe durch die Merkmale des Patentanspruches 1.

Der Erfindung liegt die Idee zugrunde, anstelle von herkömmlichen Plattenkondensatoren und Hochleistungsfunkenstrecken Wickelkondensatoren und Halbleiterschalter einzusetzen, wodurch sich der Bauraum reduziert. Die Pulsformung wird dabei durch eine Spule mit Freilaufdiode realisiert.

Die US 5,914,974 A beschreibt ein verfahren und eine Vorrichtung zur unterdrückung reflektierender Energie. Die beschriebene Anordnung basiert auf mehreren, hintereinander geschalteten Kreisen (Stufen), bestehend aus jeweils einem Kondensator und einer Spule sowie einer Diode und einem Widerstand.

Die US 5,559,404 A offenbart ein kapazitives Pulsformnetzwerk mit einer Funkenstrecke. Programmierbare Schalter im Zusammenspiel mit den Kondensatoren des Netzwerkes haben die Aufgabe der Zuschaltung der einzelnen Kondensatoren nacheinander zu bewerkstelligen. Das nichtlineare oder das lineare Verhalten der unterschiedlichen Kondensatoren dient zur Erlangung gleichmäßige Pulse.

Ein solcher Wickelkondensator ist aus der DE 198 14 700 A1 bekannt, der bei geringen Abmaßen eine hohe Energiespeicherdichte aufweist.

Als Halbleiterschalter sind lichtgeschaltete Thyristoren, wie in der DE 196 50 762 A1 beschrieben, anwendbar.

In einer besonderen Ausführung besteht der Wickelkondensator aus gewickelten metallbeschichteten Polypropylenfolien, die in einem Gehäuse untergebracht, miteinander verschaltet und eingegossen sind. Vergossen wird der Aufbau mit einem Kunstharz, wodurch Instabilitäten insbesondere beim mobilen Einsatz der Pulsstromversorgung vermieden werden.

In einer vorzugsweisen Ausführung ist die Spule als Toroid bzw. in toroidaler Bauform ausgeführt. Im mittigen, magnetfeldfreien Bereich kann der / die lichtgeschalteten Thyristoren eingebracht werden, wodurch sich weiterer Bauraum reduzieren läßt. Die Nutzung des Innenraumes der Spule ist möglich, da bekanntlich bei Toroidspulen im mittigen Bereich kein Magnetfeld vorhanden ist, da dieses im Spulenkörper gehalten wird.

Durch die Verwendung von lichtgezündeten Thyristoren kann die komplizierte Ansteuerelektronik bekannter Thyristoren entfallen.

Der mechanische Aufbau der Pulsstromversorgung ist schichtweise und derart, daß über diesen Aufbau die elektrische Kontaktierung erfolgt, so daß keine Kabelverbindungen benötigt werden und wodurch die gesamte Pulsstromversorgung mechanisch und elektrisch stabil ausgeführt ist.

Anhand eines Ausführungsbeispiels mit Zeichnung soll die Erfindung näher erläutert werden. Es zeigt:
- Figur 1: einen Prinzipschaltplan einer Pulsstromversorgung
- Figur 2: einen mechanischen Aufbau der Pulsstromversorgung aus Figur 1
- Figur 2a: eine Draufsicht auf die Pulsstromversorgung aus Figur 2
- Figur 3: eine Schnittdarstellung (auszugsweise) eines Wickelkondensators
- Figur 4: die Zusammenschaltung mehrerer Wickelkondensatoren zu einem Hochlei- stungskondensator

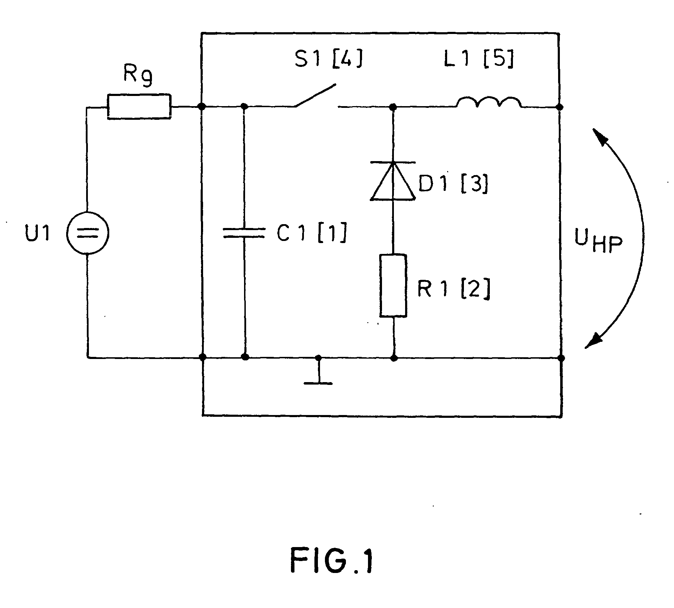

In Figur 1 ist in einem Prinzipschaltplan eine Pulsstromversorgung dargestellt. Diese weist eine Spannungsquelle U₁ mit zugehöriger Anpassungs- und Schutzelektronik auf, die der Übersichtlichkeit halber als Gesamtwiderstand Rg bezeichnet und dargestellt ist. An dieser Spannungsquelle U₁ angeschlossen sind ein parallel zur Spannungsquelle U₁ liegender Hochleistungskondensator 1, dem ein Halbleiterschalter 4 in Reihe und dazu eine Diode 3 als Freilaufdiode und ein Widerstand 2 als Dämpfungswiderstand parallel geschaltet sind, so wie eine Spule 5, die eingangsseitig zwischen dem Halbleiterschalter 4 und der Diode 3 eingebunden ist und ausgangsseitig eine Hochleistungsspannung U_{HP} liefert.

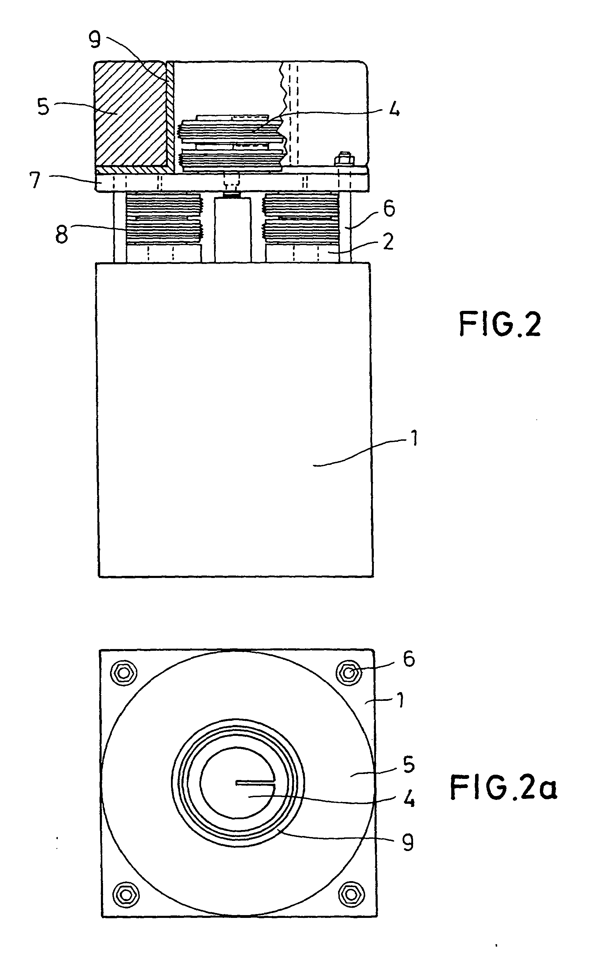

Der mechanische Aufbau der Pulsstromvorrichtung 10 ist in Figur 2 dargestellt, wobei die Spannungsquelle U₁ und der Gesamtwiderstand Rg nicht näher dargestellt, jedoch vorzugsweise in diesem Aufbau eingebunden sind.

Wie in Figur 2 dargestellt, ist die Pulsstromvorrichtung schichtartig aufgebaut. Den Grundbestandteil bildet der Hochleistungskondensator 1, der aus einem oder mehreren Wikkelkondensatoren 20 gebildet wird, die in einem Gehäuse 1.1 eingebracht und verschaltet sind (wird noch ausgeführt). Auf dem Hochleistungskondensator 1 sind der Widerstand 2 und die Diode 3 nacheinander mechanisch angebracht und gleichzeitig elektrisch verschaltet. Der Widerstand 2 ist dabei vorzugsweise als Keramikscheibe ausgebildet. Über eine Kontaktplatte 7, aus Aluminium oder Stahl, ist die Diode 3 einmal mit der Spule 5 und einmal mit dem im Spulenfreiraum 5.1 angeordneten Hochleistungsschalter 4 verschaltet. Die Spule 5 ist in toroidaler Bauform als Hochstromspule ausgebildet. Die toroidale Bauform gewährleistet, daß im Spulenfreiraum ein an der Spule 5 sich aufbauendes Magnetfeld gleich Null ist, da das Magnetfeld im Wickelkörper der Spule 5 verbleibt. Elektromagnetische Felder nach außen treten durch diese Bauform nicht auf. Der Halbleiterschalter 4 wird aus einem oder mehreren in Reihe geschalteten lichtgeschalteten Thyristoren gebildet. Zwischen dem Halbleiterschalter 4 und der Spule 5 sowie der Spule 5 und der Kontaktplatte 7 ist ein Isolierkörper 9 eingebunden, der vorzugsweise eine beidseitig offene Hutform besitzt. Zusammengehalten wird dieser schichtartige Aufbau durch GFK-Gewindestäbe 6.

In Figur 2a ist die Pulsstromversorgung in einer Draufsichtdarstellung aufgezeigt. Die Außenmaße der gesamten Pulsstromversorgung sind ca. bei einem elektrischen Energieinhalt von ca. 120 KJ 400 x 400 x 750, wodurch diese Pulsstromversorgung bequem in ein Fahrzeug (nicht näher dargestellt) integrierbar ist. Hier kann dann als Spannungsquelle U₁ eine Fahrzeugbatterie fungieren.

Die bauliche Reduzierung ist vorrangig auf den besonderen Aufbau des Hochleistungskondensators 1 zurückzuführen, der aus mehreren miteinander elektrisch verbundenen Wickelkondensatoren 20 besteht.

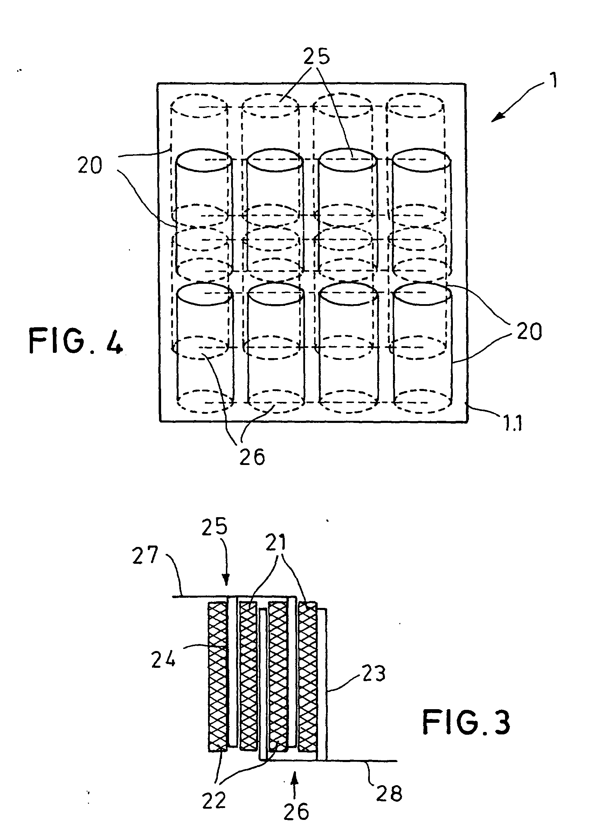

In Figur 3 ist der prinzipielle Aufbau des Wickelkondensators 20 dargestellt. Dabei sind zwei Polypropylenfolien 21, 22 mit je einer metallischen Schicht 23, 24, beispielsweise Aluminium, beschichtet und danach zum Kondensator 20 gewickelt. Die einzelnen gewickelten Folien 21, 22 werden mit ihren Schichten 23, 24 an der oberen Stirnseite 25 bzw. unteren Stirnseite 26 verbunden, wodurch sich die Außenanschlüsse 27, 28 des Wickelkondensators 20 ergeben. Die Folien 21, 22 bilden das Dielektrikum und weisen eine hohe Durchschlagfestigkeit auf. Die Schichten 23, 24 bilden die Elektroden. Dabei gilt zu beachten, daß je dünner die Elektroden 23, 24 im Verhältnis zu den Folien 21, 22 sind, desto höher ergibt sich die elektrische Energiedichte des Kondensators. Daher weisen die Folien 21, 22 eine Dicke in µm - und die Schichten 23, 24 eine Dicke im nm-Bereich auf.

Zur Integration einer derartigen Pulsstromversorgung in ein Fahrzeug zum Zwecke der Versorgung eines elektrischen oder teilelektrischen Waffensystems benötigt man in etwa eine Energiedichte von mindestens 2 MJ pro Kubikmeter. Dazu werden mehrere Wickelkondensatoren 20 in das Gehäuse 1.1 eingebracht und zu einem großen Hochleistungskondensator 1 verschaltet, wie in Figur 4 dargestellt. Das Gehäuse 1.1 wird vorzugsweise mit Kunstharz, beispielsweise ein Eproxydharz, vergossen.

Es sei noch erwähnt, daß unter Fahrzeugen neben Kraft- und Nutzfahrzeugen, Flugzeugen und Schiffen, Panzer oder panzerartige Fahrzeuge, Kanonen, Haubitzen usw. verstanden werden. Der mobile Einsatz ist aber nicht auf Fahrzeuge dieser Art beschränkt.

### Bezugszeichenliste

- U₁: Spannungsquelle
- Rg: Gesamtwiderstand Anpassung
- 1: HED-Kondensator
- 1.1: Gehäuse des Kondensators
- 2: Dämpfungswiderstand
- 3: Freilaufdiode
- 4: Halbleiterschalter
- 5: Hochstromspule
- 6: Gewindestab (GFK gerichtet)
- 7: Kontaktplatte
- 9: Isolierkörper
- 20: Wickelkondensator
- 21: Folien
- 22: Folien
- 23: metallische Schichten
- 24: metallische Schichten
- 25: obere Stirnseite
- 26: untere Stirnseite
- 27: Anschluß
- 28: Anschluß

## Patentansprüche

1. Pulsstromversorgung zur Erzeugung von insbesondere Hochleistungspulsen, aufweisend eine Spannungsquelle (U1), die mit einem Energiespeicher verbunden ist, einen Hochleistungsschalter (S1) zur Freigabe der gespeicherten Energie sowie einer nachfolgenden Pulsformeinrichtung, wobei als Energiespeicher ein Hochleistungskondensator (1) fungiert, der aus mehreren Wickelkondensatoren (20) besteht, die zu mehreren elektrisch miteinander verschaltet sind, und als Hochleistungsschalter (4) ein Halbleiterschalter eingesetzt wird, der dem Hochleistungskondensator (1) nachgeschaltet ist, **dadurch gekennzeichnet, dass**
• die Pulsstromversorgung schichtartig aufgebaut ist, wobei die mehreren Wickelkondensatoren (20) in einem gemeinsamen Gehäuse (1.1) integriert sind, auf dem eine Diode (3) und ein Widerstand (2) mechanisch befestigt sind, wobei
• auf der Diode (3) eine Kontaktplatte (7) angeordnet ist, die mit einer Spule (5) mechanisch verbunden ist,
• in einem Spulenfreiraum (5.1) der Hochleistungsschalter (4) angeordnet ist, der auf der Kontaktplatte (7) befestigt ist, und
• zwischen dem Hochleistungsschalter (4) und der Spule (5) sowie der Spule (5) und der Kontaktplatte (7) ein Isolierkörper (9) eingebunden ist.

2. Pulsstromversorgung nach Anspruch 1, **dadurch gekennzeichnet, dass** der Halbleiterschalter (4) aus ein oder mehreren lichtgeschalteten Thyristoren gebildet wird.

3. Pulsstromversorgung nach einem der Ansprüche 1 oder 2, **dadurch gekennzeichnet**, das die Spule (5) als Toroidspule ausgeführt ist.

4. Pulsstromversorgung nach einem der Ansprüche 1 bis 3, **dadurch gekennzeichnet, dass** über die mechanischen Verbindungen die elektrischen Kontakte realisiert werden.

5. Pulsstromversorgung nach einem oder mehreren der vorgenannten Ansprüche 1 bis 4, **dadurch gekennzeichnet, dass**
- ein Wickelkondensator (20) aus gewickelten Polypropylenfolien (21, 22) besteht, die metallisch beschichtet sind, wobei die Polypropylenfolien (21, 22) als Dielektrikum fungieren.

6. Pulsstromversorgung nach Anspruch 5, **dadurch gekennzeichnet, dass** Schichten (23, 24) die Elektroden bilden, wobei je dünner die Elektroden (23, 24) im Verhältnis zu den Folien (21, 22) sind, desto höher sich die elektrische Energiedichte des Wickelkondensators (20) ergibt.

7. Pulsstromversorgung nach einem der Ansprüche 1 bis 6, **dadurch gekennzeichnet, dass** mehrere Wickelkondensatoren (20) in ein Gehäuse (1.1) eingebracht werden und verbleibende Hohlräume zwischen den Wickelkondensatoren (20) im Gehäuse (1.1) mit Kunstharz vergossen sind.

8. Fahrzeug mit einer Pulsstromversorgung nach einem der Ansprüche 1 bis 7.

## Claims

1. Pulsed-current supply for generating in particular high-power pulses, having a voltage source (U1), which is connected to an energy store, a high-power switch (S1) for releasing the stored energy and a downstream pulse-shaping device, wherein a high-power capacitor (1) which consists of a plurality of wound capacitors (20) which, in groups of more than one, are electrically connected to one another acts as the energy store and a semiconductor switch which is connected downstream of the high-power capacitor (1) is used as the high-power switch (4), **characterized in that**
• the pulsed-current supply has a stratified design, wherein the plurality of wound capacitors (20) are integrated in a common housing (1.1), on which a diode (3) and a resistor (2) are fastened mechanically, wherein
• a contact plate (7), which is mechanically connected to a coil (5), is arranged on the diode (3),
• the high-power switch (4), which is fastened on the contact plate (7), is arranged in a coil free space (5.1), and
• an insulating body (9) is integrated between the high-power switch (4) and the coil (5) as well as between the coil (5) and the contact plate (7).

2. Pulsed-current supply according to Claim 1, **characterized in that** the semiconductor switch (4) is formed from one or more light-switched thyristors.

3. Pulsed-current supply according to either of Claims 1 and 2, **characterized in that** the coil (5) is in the form of a toroidal coil.

4. Pulsed-current supply according to one of Claims 1 to 3, **characterized in that** the electrical contacts are implemented by means of the mechanical connections.

5. Pulsed-current supply according to one or more of the preceding Claims 1 to 4, **characterized in that**
- a wound capacitor (20) consists of wound polypropylene films (21, 22), which are metal-plated, wherein the polypropylene films (21, 22) act as a dielectric.

6. Pulsed-current supply according to Claim 5, **characterized in that** layers (23, 24) form the electrodes, wherein the thinner the electrodes (23, 24) are in relation to the films (21, 22), the higher the electrical energy density of the wound capacitor (20).

7. Pulsed-current supply according to one of Claims 1 to 6, **characterized in that** a plurality of wound capacitors (20) are introduced into a housing (1.1) and remaining cavities between the wound capacitors (20) in the housing (1.1) are cast with synthetic resin.

8. Vehicle with a pulsed-current supply according to one of Claims 1 to 7.

## Revendications

1. Alimentation électrique pulsée pour générer notamment des impulsions de grande puissance, présentant une source de tension (U1) qui est reliée avec un accumulateur d'énergie, un commutateur de grande puissance (S1) pour libérer l'énergie accumulée ainsi qu'un dispositif de conformation d'impulsions disposé à la suite, un condensateur de grande puissance (1) faisant office d'accumulateur d'énergie, lequel se compose de plusieurs condensateurs bobinés (20) qui sont connectés électriquement entre eux, et le commutateur de grande puissance (4) utilisé étant un commutateur à semiconducteur qui est branché à la suite du condensateur de grande puissance (1), **caractérisée en ce que**
* l'alimentation électrique pulsée est construite à la manière de couches, les plusieurs condensateurs bobinés (20) étant intégrés dans un boîtier commun (1.1) sur lequel sont fixées mécaniquement une diode (3) et une résistance (2),
* une plaque de contact (7) étant disposée sur la diode (3), laquelle est reliée mécaniquement avec une bobine (5),
* le commutateur de grande puissance (4), qui est fixé sur la plaque de contact (7), est disposé dans un espace libre de bobine (5.1) et
* un corps isolant (9) est inséré entre le commutateur de grande puissance (4) et la bobine (5) et aussi entre la bobine (5) et la plaque de contact (7).

2. Alimentation électrique pulsée selon la revendication 1, **caractérisée en ce que** le commutateur à semiconducteur (4) est constitué d'un ou plusieurs thyristors à commutation libre.

3. Alimentation électrique pulsée selon la revendication 1 ou 2, **caractérisée en ce que** la bobine (5) est réalisée sous la forme d'une bobine toroïdale.

4. Alimentation électrique pulsée selon l'une des revendications 1 à 3, **caractérisée en ce que** les contacts électriques sont réalisés par le biais de liaisons mécaniques.

5. Alimentation électrique pulsée selon une ou plusieurs des revendications précédentes 1 à 4, **caractérisée en ce qu'**un condensateur bobiné (20) se compose de films en polypropylène bobinés (21, 22) qui comportent un revêtement métallique, les films en polypropylène (21, 22) faisant office de diélectrique.

6. Alimentation électrique pulsée selon la revendication 5, **caractérisée en ce que** des couches (23, 24) forment les électrodes, plus les électrodes (23, 24) étant minces par rapport aux films (21, 22), plus la densité d'énergie électrique du condensateur bobiné (20) obtenue étant élevée.

7. Alimentation électrique pulsée selon l'une des revendications 1 à 6, **caractérisée en ce que** plusieurs condensateurs bobinés (20) sont logés dans un boîtier (1.1) et les espaces creux restants entre les condensateurs bobinés (20) dans le boîtier (1.1) sont scellés avec de la résine synthétique.

8. Véhicule équipé d'une alimentation électrique pulsée selon l'une des revendications 1 à 7.
